# EUROPEAN PATENT APPLICATION

(11) **EP 4 821 739 A1**
(43) Date of publication of application: **14.10.2026**
(21) Application number: 25170079.5
(22) Date of filing: 11.04.2025
(51) Int. Cl.: B60L 3/00, G01R 31/36, G01R 31/52, B60L 3/12, B60L 58/16

(54) **POWER FAULT DETECTION IN ELECTRICAL ENERGY STORAGE SYSTEMS BASED ON REFERENCE FLEET DATA**

(71) Applicant: Volvo Truck Corporation, 405 08 Göteborg (SE)
(72) Inventor: LILLMAA, Henri, 463 72 LÖDÖSE (SE); RAY, Dripta, 412 48 GÖTEBORG (SE)
(74) Representative: Kransell & Wennborg KB

(57) **Abstract**

A computer system (100) comprising processing circuitry (102) configured to: acquire an electrical parameter value (Ep) of an electrical energy storage pack (104a) of a first unit in a unit fleet (105), retrieve reference data (110) generated from logged electrical parameter values of electrical energy storage packs in the fleet of units, the retrieved reference data being determined from logged electrical parameter values (114) associated with units having at least one driving or usage attribute (112, 111) in common with the first unit, compare the acquired electrical parameter value with the retrieved reference data, provide an indication message (M) of a power path fault depending on the outcome of the comparison.

## Description

### TECHNICAL FIELD

The disclosure relates generally to electrical energy storage systems. In particular aspects, the disclosure relates to power fault detection in electrical energy storage systems based on reference fleet data. The disclosure can be applied to heavy-duty vehicles, such as trucks, buses, and construction equipment, among other vehicle types such as passenger cars. Although the disclosure may be described with respect to a particular vehicle, the disclosure is not restricted to any particular vehicle. The disclosure can be applied to marine vessels and industrial applications, and stationary applications.

### BACKGROUND

Energy Storage Systems (ESS) in electric vehicles (EVs) and other battery-powered applications rely on high-voltage (HV) interconnections to ensure efficient power delivery. Over time, these interconnections may develop faults due to factors such as mechanical stress, thermal cycling, vibrations, or improper assembly. Such faults can lead to increased connection resistance, power losses, and, in severe cases, thermal runaway or electrical arcing.

### SUMMARY

According to a first aspect of the disclosure, there is provided a computer system comprising processing circuitry configured to: acquire an electrical parameter value of an electrical energy storage pack of a first unit in a unit fleet, retrieve reference data generated from logged electrical parameter values of electrical energy storage packs in the fleet of units, the retrieved reference data being determined from logged electrical parameter values associated with units having at least one driving or usage attribute in common with the first unit, compare the acquired electrical parameter value with the retrieved reference data, provide an indication message of a power path fault depending on the outcome of the comparison.

The first aspect of the disclosure may seek to provide early and accurate detection of power path faults in an electrical energy storage system (ESS) within a fleet of units. A technical benefit may include improved accuracy and reliability in detecting power path faults in an Energy Storage System (ESS) within a fleet of units. Specifically, by utilizing fleet-based reference data instead of static thresholds. Further, the technical advantage is that the number of false positives can be reduced by using fault detection criteria based on real-world data from similar units compared to e.g., traditional static threshold methods which may misinterpret normal ESS ageing as a power path fault.

Preferable, a unit is herein a vehicle, although other units such as marine vessels or stationary electrical energy storage applications are applicable.

The comparison between the acquired electrical parameter value and the retrieved reference data may include to evaluate whether the acquired electrical parameter value fulfill a criterion set by the reference data. To fulfill a criterion may be to deviate from or exceed a threshold. For example, when the acquired electrical parameter deviates from the reference data by more than threshold, provide an indication message of a power path fault.

Optionally, in some examples, including in at least one preferred example, the reference data are dynamic and adjustable based on further logged electrical parameter values from units of the fleet. A technical benefit may be that by continuously incorporating new data, the expected electrical parameter behavior can be better understood and reflected in the reference data, reducing both false positives and false negatives in fault detection. Furthermore, as new units such as vehicles with different driving conditions, ambient temperatures, and load profiles are added to the fleet, the reference data is adapted accordingly, making the fault detection more accurate. Furthermore, using more reference data enhances the accuracy of the fault detection further, by improving the statistical accuracy.

Optionally, in some examples, including in at least one preferred example, the processing circuitry is further configured to detect a deviation between the electrical parameter value for the electrical energy storage pack of the first unit and the retrieved reference data, and to determine that the deviation fulfills a criterion set to reflect that the deviation is larger than what is expected from cell degradation, whereby the output indicates that a power path fault has occurred. The criterion may be a threshold, whereby the deviation is compared to the threshold, and if the deviation is larger than the threshold, the output indicates that a power path fault has occurred. A technical advantage is that since only significant deviations, i.e., those exceeding expected variations due to normal ESS aging, are classified as power path faults, the reliability and robustness of the fault detection is improved. Furthermore, by establishing a criterion that differentiates between expected cell degradation and true power path faults, false detections are minimized while ensuring that the relevant power path faults are detected. In this way, units are not indicated for service unless an actual power path fault is present, leading to cost savings by preventing unnecessary servicing or part replacements.

Optionally, in some examples, including in at least one preferred example, the driving or usage attribute includes at least one of: type of unit, driving profile, ambient temperature, electrical energy storage pack energy throughput, or electrical energy storage pack type. A technical advantage may be that static thresholds applied across all units may not account for variations due to usage conditions. By refining the reference dataset based on relevant attributes, the system improves fault detection precision.

Optionally, in some examples, including in at least one preferred example, the electrical parameter value is one of internal resistance, pack-to-pack delta SoC, or pack-to-pack current delta/current split difference. Preferably, the internal resistance is used as the electrical parameter. However, other electrical parameters are also applicable.

Optionally, in some examples, including in at least one preferred example, the processing circuitry is further configured to upload electrical parameter values of the first unit and outcomes of the comparison to a database of logged electrical parameter values to update the reference data stored in the database. In this way, the reference data can be kept up to date and further provide for more accurate and reliable fault detections.

Optionally, in some examples, including in at least one preferred example, the processing circuitry is further configured to provide the indication of a power path fault to an HMI in a vehicle cab. By displaying fault notifications directly on the HMI, the driver may take prompt action, such as stopping the vehicle or seeking maintenance. Early warnings allow for preventive action before a fault escalates into a serious safety hazard.

Optionally, in some examples, including in at least one preferred example, the processing circuitry is further configured to disconnect the faulty electrical energy storage pack from a voltage bus. By disconnecting a failing pack, further degradation may be prevented, allowing service personnel to address the issue before it worsens, reducing repair costs. Furthermore, safety for occupants of the unit, such as a vehicle may be improved by reducing the risk of overheating. Further, in some situations, isolating only the affected pack provides the ability that the vehicle can continue operating on the remaining healthy packs.

Optionally, in some examples, including in at least one preferred example, the reference data is a preferred range or distribution of the electrical parameter for units having at least one driving or usage attribute in common with the first unit. By using a dynamic range based on fleet data rather than an arbitrary limit, a better differentiation between expected ESS aging behavior and actual power path faults can be made to thereby minimize incorrect fault indications. Furthermore, by relying on statistically derived preferred ranges, the fault detection accuracy can be improved by accounting for real-world variations in unit operation.

Optionally, in some examples, including in at least one preferred example, a vehicle comprises the computer system.

According to a second aspect of the disclosure, there is provided a computer system comprising processing circuitry configured to: acquire electrical parameter values of electrical energy storage packs in a fleet of units, acquire a driving or usage attribute of the units indicating driving or usage behavior of the units or electrical energy storage packs, process the acquired electrical parameter values to determine reference data that reflect the typical electrical parameter values for a functional electrical energy storage pack of each driving or usage attribute, store the reference data along with their associated driving or usage attribute on a memory storage device, receive a request for reference data from a first unit of the fleet, the request including a driving or usage attribute, provide, to the first unit, reference data associated with the requested driving or usage attribute.

The second aspect of the disclosure may seek to generate and managing reference data based on electrical parameter values and driving or usage attributes across a fleet of units. This system enables units to request and receive context-specific reference data for fault detection. The unit or units may be vehicles.

According to a third aspect of the disclosure, there is provided a computer-implemented method comprising: acquiring, by processing circuitry of a computer system, an electrical parameter value of an electrical energy storage pack of a first unit in a unit fleet, retrieving, by the processing circuitry, reference data generated from logged electrical parameter values of electrical energy storage packs in the fleet of units, the retrieved reference data being determined from logged electrical parameter values associated with units having at least one driving or usage attribute in common with the first unit, comparing, by the processing circuitry, the acquired electrical parameter value with the retrieved reference data, providing, by processing circuitry, an indication of a power path fault depending on the outcome of the comparison.

The third aspect of the disclosure may seek to provide early and accurate detection of power path faults in an electrical energy storage system (ESS) within a fleet of units. A technical benefit may include improved accuracy and reliability in detecting power path faults in an Energy Storage System (ESS) within a fleet of units. Specifically, by utilizing fleet-based reference data instead of static thresholds. Further, the technical advantage is that the number of false positives can be reduced by using fault detection criteria based on real-world data from similar units compared to e.g., traditional static threshold methods which may misinterpret normal ESS ageing as a power path fault.

Optionally, in some examples, including in at least one preferred example, the reference data are dynamic and adjustable based on further logged electrical parameter values from units of the fleet. A technical benefit may be that by continuously incorporating new data, the expected electrical parameter behavior can be better understood reflected in the reference data, reducing both false positives and false negatives in fault detection. Furthermore, as new units with different driving conditions, ambient temperatures, and load profiles are added to the fleet, the reference data is adapted accordingly, making the fault detection more robust. Furthermore, using more data for determining the reference data enhances the accuracy of the fault detection further, by improving the statistical accuracy.

Optionally, in some examples, including in at least one preferred example, the method further comprises detecting, by the processing circuitry, a deviation between the electrical parameter value for the electrical energy storage pack of the first unit and the retrieved reference data, and determining, by the processing circuitry, that the deviation fulfills a criterion set to reflect that the deviation is larger than what is expected from cell degradation, whereby the output indicates that a power path fault has occurred. A technical advantage is that since only significant deviations, i.e., those exceeding expected variations due to normal ESS aging, are classified as power path faults, the reliability and robustness of the fault detection is improved. Furthermore, by establishing a criterion that differentiates between expected cell degradation and true power path faults, false detections are minimized while ensuring that the relevant power path faults are detected. In this way, units are not indicated for service unless an actual power path fault is present, leading to cost savings by preventing unnecessary servicing or part replacements.

Optionally, in some examples, including in at least one preferred example, the driving or usage attribute includes at least one of: type of unit, driving profile, ambient temperature, electrical energy storage pack energy throughput, or electrical energy storage pack type. A technical advantage may be that static thresholds applied across all units may not account for variations due to usage conditions. By refining the reference dataset based on relevant attributes, the system improves fault detection precision.

Optionally, in some examples, including in at least one preferred example, the electrical parameter value is one of internal resistance, pack-to-pack delta SoC, or pack-to-pack current delta/current split difference. Preferably, the internal resistance is used as the electrical parameter. However, other electrical parameters are also applicable.

Optionally, in some examples, including in at least one preferred example, the method further comprises uploading, by the processing circuitry, electrical parameter values of the first unit and outcomes of the comparison to a database of logged electrical parameter values to update the reference values stored in the database. In this way, the reference data can be kept up to date and further provide for more accurate and reliable fault detections.

Optionally, in some examples, including in at least one preferred example, the method further comprises providing, by the processing circuitry, the indication of a power path fault to an HMI in a vehicle cab. By displaying fault notifications directly on the HMI, the driver may take prompt action, such as stopping the vehicle or seeking maintenance. Early warnings allow for preventive action before a fault escalates into a serious safety hazard.

Optionally, in some examples, including in at least one preferred example, the method further comprises disconnecting, by processing circuitry, the faulty electrical energy storage pack from a voltage bus. By disconnecting a failing pack, further degradation may be prevented, allowing service personnel to address the issue before it worsens, reducing repair costs. Furthermore, safety for occupants of the unit may be improved by reducing the risk of overheating. Further, in some situations, isolating only the affected pack provides the ability that the unit can continue operating on the remaining healthy packs.

Optionally, in some examples, including in at least one preferred example, the reference data is a preferred range or distribution of the electrical parameter for units having at least one driving or usage attribute in common with the first unit. By using a dynamic range based on fleet data rather than an arbitrary limit, a better differentiation between expected ESS aging behavior and actual power path faults can be made to thereby minimize incorrect fault indications. Furthermore, by relying on statistically derived preferred ranges, the fault detection accuracy can be improved by accounting for real-world variations in unit operation.

There is further provided a computer program product comprising program code for performing, when executed by processing circuitry, the method as described in the third aspect.

There is further provided a non-transitory computer-readable storage medium comprises instructions, which when executed by the processing circuitry, cause the processing circuitry to perform the method as described in the third aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary system diagram of a computer system according to an example.
**FIG. 2** is an exemplary system diagram of a computer system according to an example.
**FIG. 3** is a flow chart of an exemplary method according to an example.
**FIG. 4** is another view of **FIG. 1****,** according to an example.
**FIG. 5** is a flow chart of an exemplary method according to an example.
**FIG. 6** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Conventional power path fault detection methods in energy storage systems typically rely on static threshold values for e.g., internal resistance, state of charge (SoC) differences, and current distribution. However, these thresholds do not account for variations in driving patterns, environmental conditions, and battery aging, which may lead to false detections or missed faults.

Additionally, in case of vehicles, detecting faults based solely on individual vehicle data can be unreliable, as normal battery degradation can mimic fault conditions. This makes it difficult to distinguish between expected aging-related resistance increases and actual power path faults, such as loose interconnections or increased contact resistance.

The invention solves this problem by considering fleet-level data, allowing for a comparative analysis of internal resistance behavior across vehicles with similar operating conditions. This approach improves fault detection accuracy, reduces false positives, and enables early identification of potential failures before they lead to power loss or safety hazards.

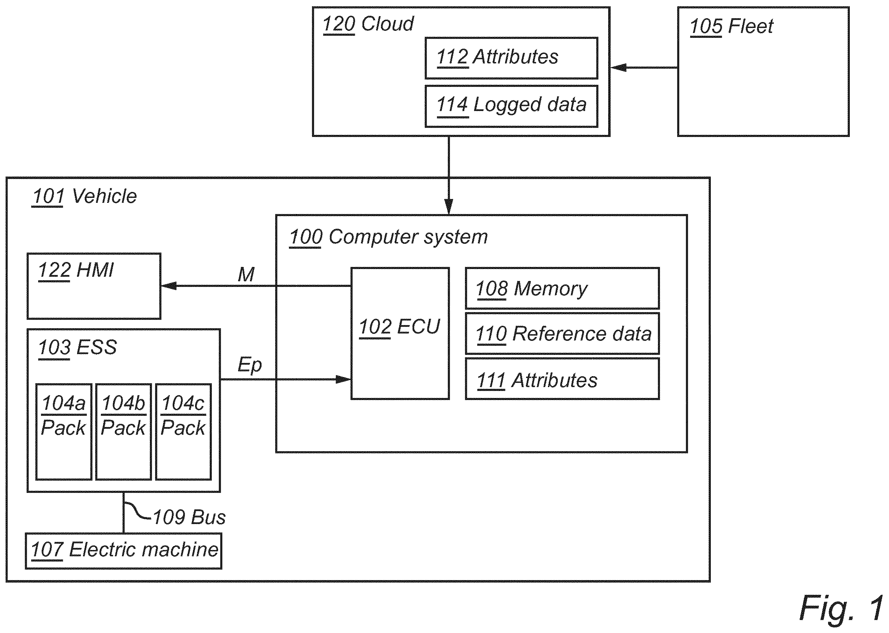

**FIG. 1** is an exemplary computer system 100 according to an example. The computer system is preferably comprised in a vehicle, here denoted a first vehicle 101. The vehicle 101 may be a heavy-duty vehicle such as a truck although the disclosure is not limited to any particular vehicle type. The examples described in more detail herein exemplify unit as a vehicle, which is the preferred embodiment, although other units are applicable such as marine vessels and stationary applications.

The computer system 100 comprises a processing circuitry 102, such as an electric control unit (ECU), and a digital data storage memory 108. The processing circuitry 102 may store data in the memory 108 and retrieve data from the memory 108.

The vehicle 101, which is part of a fleet 105 of vehicles, comprises an electrical energy storage system 103 (ESS) comprising multiple electrical energy storage packs 104a-c. The electrical energy storage system 103 is configured to provide electrical power to an electric machine 107 via a voltage bus 109. That is, the electrical energy storage packs 104a-c are electrically connected to the voltage bus 109 to provide electrical power, via the voltage bus 109, to the electric machine 107. The electrical energy storage packs 104a-c are individually connectable and disconnectable to the voltage bus. In other words, the processing circuitry 102 can control switches between the electrical energy storage packs 104a-c and the voltage bus 109 to connect and disconnect individual electrical energy storage packs 104a-c to/from the voltage bus 109.

The electrical energy storage packs 104a-c each include a plurality of electrical energy storage cells electrically connected in series and/or parallel. The cells are based on a suitable technology such as Li-Ion technology.

The processing circuitry 102 is configured to acquire an electrical parameter value Ep of a first electrical energy storage pack 104a among the multiple electrical energy storage packs 104a-c of the first vehicle 101 in the vehicle fleet 105. Preferably, the ESS is a multi-pack 104a-c system.

The electrical parameter value is one of internal resistance, pack-to-pack delta SoC, pack-to-pack current delta or pack-to-pack current split difference. Preferably, the internal resistance of the electrical energy storage pack 104a is used as the electrical parameter. In some examples, a combination of electrical parameters can be used. For example, pack-to-pack SoC delta and current split could be used together with the internal resistance to increase the robustness. Pack-to-pack electrical current split is dynamic and could provide faster fault detection.

Briefly, although known *per* se, pack-to-pack current split or difference refers to, in case of multiple electrical energy storage packs in parallel connection and due to multiple different variations, such as cell different aging, cable length, connection quality, etc, the load current is not split equally among the packs, but instead differs due to packs and interconnect having slightly different resistances.
The electrical current delta or current split among the battery packs over some time could lead to different states of charges among the electrical energy storage packs.

The internal resistance can be determined in various ways such as using estimation methods including Kalman filtering and machine learning on operating conditions and historical data, or by using measurement methods including applying a current pulse to the electrical energy storage pack and analyzing the voltage drop before and after the pulse and then using the well-known Ohm's law. Typically, internal resistance can be provided by an ESS management unit of the vehicle.

The processing circuitry 102 is configured to retrieve reference data 110 generated from logged electrical parameter values 114 of electrical energy storage packs in the fleet 105 of vehicles. The retrieved reference data 110 being determined from logged electrical parameter values 114 associated with vehicles, in the fleet 105, having at least one driving or usage attribute 112, 111 in common with the first vehicle 101. In other words, the logged data 114 is tagged with and categorized based on meta-data indicating the driving or usage attribute 112 of the vehicles in the fleet 105 from which the data 114 was acquired. The reference data 110 are dynamic and adjustable based on further logged electrical parameters values 114 from vehicles of the fleet 105. The logged data 114 and associated attributes 112 are stored in a cloud-based database 120 accessible to the computer system 100.

The driving or usage attribute includes at least one of: type of vehicle, driving profile, ambient temperature, electrical energy storage pack energy throughput, or electrical energy storage pack type. Type of vehicle includes e.g., medium duty truck, heavy duty truck, bus. Energy throughput may be the energy that has been charged and discharged during the entire life of the electrical energy storage pack. Electrical energy storage type may relate to configuration of packs and cells or the technology/chemistry of the electrical energy storage.

The processing circuitry 102 thus compares the acquired electrical parameter value Ep with the retrieved reference data 110. The retrieved reference data 110 is associated with vehicles having similar or the same attributes 112 as the attribute 111 of the first vehicle 101, meaning that the acquired electrical parameter value Ep is compared with reference data 110 from the database 120 that most closely resembles the driving and usage conditions of the first vehicle 101.

As an example, the fleet attributes "a", "b", "c" and internal resistances 114 may be logged. Then based on the attributes 111 for a particular vehicle with a value or range/distribution of expected healthy internal resistance values may be generated and sent back to the vehicle 101 where the comparison is then made. Thus, the reference data 110 may be a preferred range or distribution of the electrical parameter for vehicles having at least one driving or usage attribute 111, 112 in common with the first vehicle 101.

The processing circuitry 102 is configured to provide an indication message M of a power path fault depending on the outcome of the comparison.

The power path is preferably power paths within an electrical energy storage pack 104a-c. In some examples, the power path may include the path which connect the larger modules consisting of small cells, contactors, fuse, and also busbars, contactors, fuse connections, etc, from the pack 104a-c to the electric machine 107.

The indication M of the power path fault may be provided to a human-machine-interface 122 (HMI) in a vehicle cab. The HMI 122 may be for example a display or a speaker.

Furthermore, the processing circuitry may be further configured to upload electrical parameter values of the first vehicle 101 and outcomes of the comparison to the database 120 of logged electrical parameter values to update the reference data 114 stored in the database 120. The vehicle 101 thus comprises suitable communication technology such as WiFi, telecommunication, V2X, that allows data exchange with the server 120.

The processing circuitry 102 may perform the comparison by detecting a deviation between the electrical parameter value Ep for the electrical energy storage pack 104a of the first vehicle 101 and the retrieved reference data 110 or a reference value derived from the reference data 110. The deviation may be a statistical deviation or a purely numeric deviation. The processing circuitry 102 is configured to determine that the deviation fulfil a criterion set to reflect that the deviation is larger than what is expected from cell degradation, whereby the output indicates that a power path fault has occurred. In some examples, the criterion is a threshold value.

The criterion or threshold for detecting power path faults may be determined through statistical analysis of electrical parameters collected from the fleet of vehicles. Data are gathered on internal resistance, SoC delta, current split differences, and other relevant parameters across vehicles with similar usage conditions, such as driving patterns, temperature, and aging effects. By analyzing trends, normal operating ranges can be established using methods like mean and standard deviation or machine learning-based anomaly detection. Any significant deviation beyond this range indicates a potential fault. The threshold may be continuously refined based on real-world performance reflected in newly detected and upload data to the database 120. Instead of using a fixed threshold, the threshold may be dynamically adapted based on the new data.

For example, with enough logged data 114 from the fleet 105, a distribution can be established from which outliers from the distribution for example electrical parameter values outside a given distribution range can be classified as belonging to a faulty electrical energy storage pack.

**In** case a faulty electrical energy storage pack 104a is detected, the processing circuitry 102 may be further configured to disconnect the faulty electrical energy storage pack from the voltage bus 109.

The ESS 103 is preferably a multi-pack 104a-c system. That the vehicle 101 is a multi-pack vehicle advantageously provides for analyzing single electrical energy storage pack parameter deviation against the parameters of other electrical energy storage pack within the vehicle as well as with reference data from the fleet -- one of such parameters could be internal resistance. However, pack-to-pack SoC delta or pack-to-pack current delta assumes that the vehicle has multiple electrical energy storage packs among which the delta SoC or electrical current difference between packs can occur.

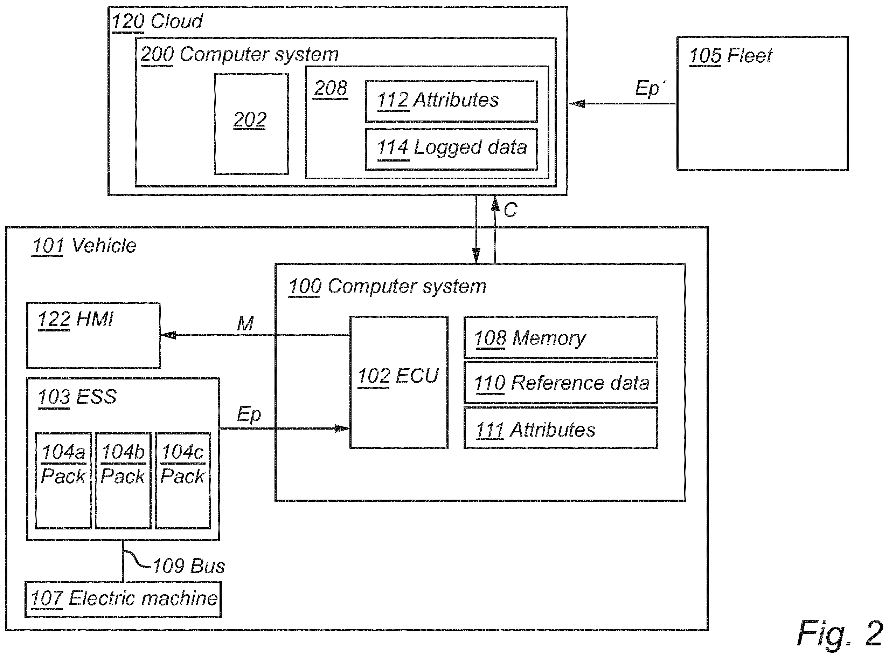

**FIG. 2** illustrates another aspect of the disclosure, including a computer system 200 preferably located on the server 120 remote from the first vehicle 101. The system 200 comprises a processing circuitry 202 configured to: acquire electrical parameter values Ep' of electrical energy storage packs in a fleet 105 of vehicles each equipped with multiple electrical energy storage packs, acquire a driving or usage attribute 112 of the vehicles indicating driving or usage behavior of the vehicles or electrical energy storage packs, process the acquired electrical parameter values Ep' to determine reference data that reflect the typical electrical parameter values for a functional electrical energy storage pack of each driving or usage attribute, store the reference data 114 along with their associated driving or usage attribute 112 on a memory storage device 208, receive a request C for reference data from a first vehicle 101 of the fleet 105, the request including a driving or usage attribute 111, provide, to the first vehicle, reference data 110 associated with the requested driving or usage attribute 111 and derived from the logged data 114.

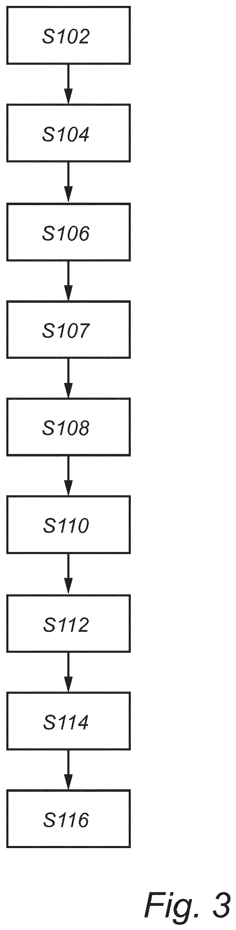

**FIG. 3** is a flow-chart of method steps according to one example.

In step S102 acquiring, by processing circuitry 102 of a computer system 100, an electrical parameter value Ep of a first electrical energy storage pack 104a among multiple electrical energy storage packs 104a-c of a first vehicle 101 in a vehicle fleet 105. The electrical parameter value Ep is at least one of internal resistance, pack-to-pack delta SoC, or pack-to-pack current delta/current split difference.

In step S104 retrieving, by the processing circuitry 102, reference data 110 generated from logged electrical parameter values 114 of electrical energy storage packs in the fleet 105 of vehicles, the retrieved reference data 110 being determined from logged electrical parameter values 114 associated with vehicles having at least one driving or usage attribute 112 in common with the first vehicle 101. The driving or usage attribute includes at least one of: type of vehicle, driving profile, ambient temperature, electrical energy storage pack energy throughput, or electrical energy storage pack type. The reference data are dynamic and adjustable based on further logged electrical parameters values from vehicles of the fleet.

**In** step S106, comparing, by the processing circuitry 102, the acquired electrical parameter value Ep with the retrieved reference data 110.

The step S106 of comparing may comprise detecting in step S107, by the processing circuitry 102, a deviation between the electrical parameter value Ep for the electrical energy storage pack 104a of the first vehicle 111 and the retrieved reference data 110 and determining, in step S108, by the processing circuitry 102, that the deviation fulfil a criterion set to reflect that the deviation is larger than what is expected from cell degradation, whereby the output M indicates that a power path fault has occurred.

In step S110 providing, by the processing circuitry 102, an indication M of a power path fault depending on the outcome of the comparison.

In step S112, uploading, by the processing circuitry 102, electrical parameter values Ep of the first vehicle 101 and outcomes of the comparison to a data base 120 of logged electrical parameter values 114 to update the reference data stored in the database 120.

In step S114 providing, by the processing circuitry 102, the indication M of a power path fault to an HMI 122 in a vehicle cab.

In step S116, disconnecting, by the processing circuitry 102, the faulty electrical energy storage pack 104a from a voltage bus 109.

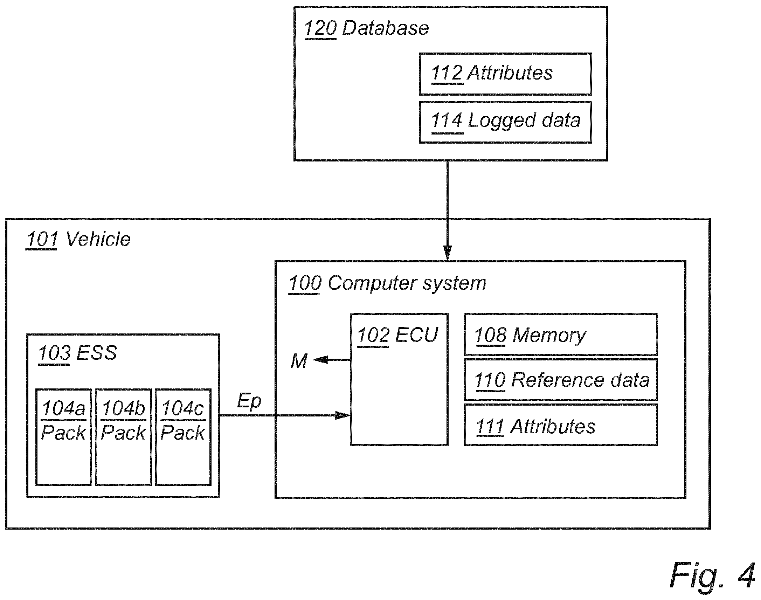

**FIG. 4** is another view of **FIG. 1****,** according to an example. A computer system 100 comprising processing circuitry 102 configured to: acquire an electrical parameter value Ep of an electrical energy storage pack 104a of a first unit in a unit fleet 105, retrieve reference data 110 generated from logged electrical parameter values 114 of electrical energy storage packs in the fleet of units, the retrieved reference data being determined from logged electrical parameter values 114 associated with units having at least one driving or usage attribute 112, 111 in common with the first unit 111, compare the acquired electrical parameter value with the retrieved reference data, provide an indication message M of a power path fault depending on the outcome of the comparison.

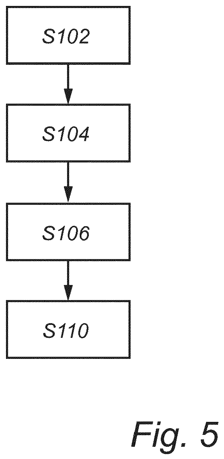

**FIG. 5** is a flow chart of a method according to an example.

Acquiring S102, by processing circuitry of a computer system, an electrical parameter value of an electrical energy storage pack of a first unit in a unit fleet,

Retrieving S104, by the processing circuitry, reference data generated from logged electrical parameter values of electrical energy storage packs in the fleet of units, the retrieved reference data being determined from logged electrical parameter values associated with units having at least one driving or usage attribute in common with the first unit,

Comparing S106, by the processing circuitry, the acquired electrical parameter value with the retrieved reference data,

Providing S110, by the processing circuitry, an indication of a power path fault depending on the outcome of the comparison.

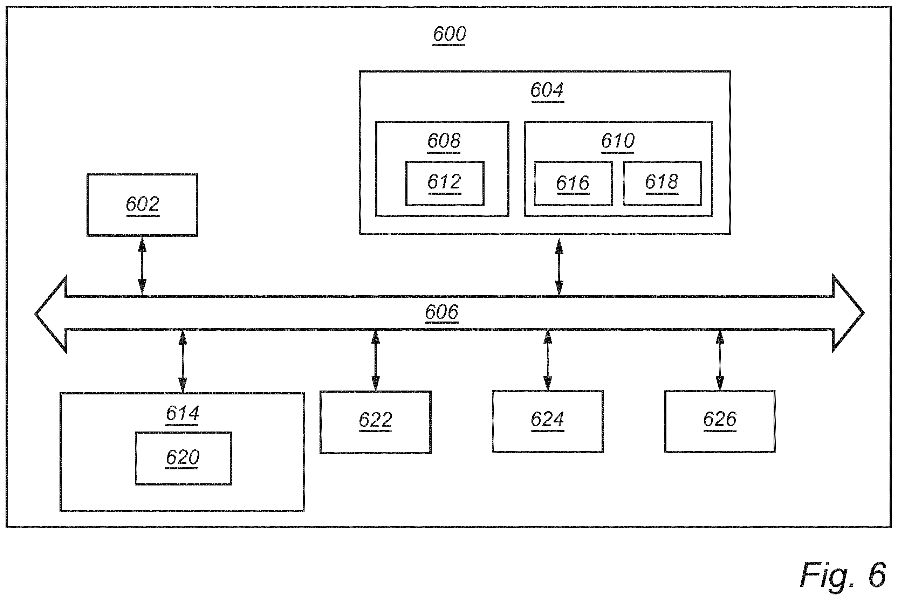

**FIG. 6** is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **600** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604,** and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: acquire an electrical parameter value of an electrical energy storage pack of a first unit in a unit fleet, retrieve reference data generated from logged electrical parameter values of electrical energy storage packs in the fleet of units, the retrieved reference data being determined from logged electrical parameter values associated with units having at least one driving or usage attribute in common with the first unit, compare the acquired electrical parameter value with the retrieved reference data, provide an indication message of a power path fault depending on the outcome of the comparison.

Example 2: The computer system of claim 1, wherein the reference data are dynamic and adjustable based on further logged electrical parameters values from units of the fleet.

Example 3: The computer system of any of claims 1-2, wherein the processing circuitry is further configured to: detect a deviation between the electrical parameter value for the electrical energy storage pack of the first unit and the retrieved reference data, determine that the deviation fulfil a criterion set to reflect that the deviation is larger than what is expected from cell degradation, whereby the output indicates that a power path fault has occurred.

Example 4: The computer system of any of claims 1-3, wherein the driving or usage attribute includes at least one of: type of unit, driving profile, ambient temperature, electrical energy storage pack energy throughput, or electrical energy storage pack type.

Example 5: The computer system of any of claims 1-4, wherein the electrical parameter value is one of internal resistance, pack-to-pack delta SoC, or pack-to-pack current delta/current split difference.

Example 6: The computer system of any of claims 1-5, wherein the processing circuitry is further configured to: upload electrical parameter values of the first unit and outcomes of the comparison to a data base of logged electrical parameter values to update the reference data stored in the database.

Example 7: The computer system of any of claims 1-6, wherein the processing circuitry is further configured to: provide the indication of a power path fault to an HMI in a unit cab.

Example 8: The computer system of any of claims 1-7, wherein the processing circuitry is further configured to: disconnect the faulty electrical energy storage pack from a voltage bus.

Example 9: The computer system of any of claims 1-8, wherein the reference data is a preferred range or distribution of the electrical parameter for units having at least one driving or usage attribute in common with the first unit.

Example 10: A unit comprising the computer system of any of claims 1-9.

Example 11: A computer system comprising processing circuitry configured to: acquire electrical parameter values of electrical energy storage packs in a fleet of units each equipped with at least one electrical energy storage pack, acquire a driving or usage attribute of the units indicating driving or usage behavior of the units or electrical energy storage packs, process the acquired electrical parameter values to determine reference data that reflect the typical electrical parameter values for a functional electrical energy storage pack of each driving or usage attribute, store the reference data along with their associated driving or usage attribute on a memory storage device, receive a request for reference data from a first unit of the fleet, the request including a driving or usage attribute, provide, to the first unit, reference data associated with the requested driving or usage attribute.

Example 12: A computer-implemented method comprising: acquiring, by processing circuitry of a computer system, an electrical parameter value of an electrical energy storage pack of a first unit in a unit fleet, retrieving, by the processing circuitry, reference data generated from logged electrical parameter values of electrical energy storage packs in the fleet of units, the retrieved reference data being determined from logged electrical parameter values associated with units having at least one driving or usage attribute in common with the first unit, comparing, by the processing circuitry, the acquired electrical parameter value with the retrieved reference data, providing, by the processing circuitry, an indication of a power path fault depending on the outcome of the comparison.

Example 13: The method of claim 12, wherein the reference data are dynamic and adjustable based on further logged electrical parameters values from units of the fleet.

Example 14: The method of any of claims 12-13, further comprising: detecting, by the processing circuitry, a deviation between the electrical parameter value for the electrical energy storage pack of the first unit and the retrieved reference data, determining, by the processing circuitry, that the deviation fulfil a criterion set to reflect that the deviation is larger than what is expected from cell degradation, whereby the output indicates that a power path fault has occurred.

Example 15: The method of claims 12-14, wherein the driving or usage attribute includes at least one of: type of unit, driving profile, ambient temperature, electrical energy storage pack energy throughput, or electrical energy storage pack type.

Example 16: The method any of claims 21-15, wherein the electrical parameter value is one of internal resistance, pack-to-pack delta SoC, or pack-to-pack current delta/current split difference.

Example 17: The method of any of claims 12-16, further comprising: uploading, by the processing circuitry, electrical parameter values of the first unit and outcomes of the comparison to a data base of logged electrical parameter values to update the reference values stored in the database.

Example 18: The method of any of claims 12-17, further comprising: providing, by the processing circuitry, the indication of a power path fault to an HMI in a unit.

Example 19: The method of any of claims 12-18, further comprising: disconnecting, by processing circuitry, the faulty electrical energy storage pack from a voltage bus.

Example 20: The method of any of claims 12-19, wherein the reference data is a preferred range or distribution of the electrical parameter for units having at least one driving or usage attribute in common with the first unit.

Example 21: A computer program product comprising program code for performing, when executed by the processing circuitry, the method of any of claims 12-20.

Example 22: A non-transitory computer-readable storage medium comprising instructions, which when executed by the processing circuitry, cause the processing circuitry to perform the method of any of claims 12-20.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) comprising processing circuitry (102) configured to:
acquire an electrical parameter value (Ep) of an electrical energy storage pack (104a) of a first unit in a unit fleet (105),
retrieve reference data (110) generated from logged electrical parameter values of electrical energy storage packs in the fleet of units, the retrieved reference data being determined from logged electrical parameter values (114) associated with units having at least one driving or usage attribute (112, 111) in common with the first unit,
compare the acquired electrical parameter value with the retrieved reference data,
provide an indication message (M) of a power path fault depending on the outcome of the comparison.

2. The computer system of claim 1, wherein the reference data are dynamic and adjustable based on further logged electrical parameters values from units of the fleet.

3. The computer system of any of claims 1-2, wherein the processing circuitry is further configured to:
detect a deviation between the electrical parameter value for the electrical energy storage pack of the first unit and the retrieved reference data,
determine that the deviation fulfil a criterion set to reflect that the deviation is larger than what is expected from cell degradation, whereby the output indicates that a power path fault has occurred.

4. The computer system of any of claims 1-3, wherein the driving or usage attribute includes at least one of: type of unit, driving profile, ambient temperature, electrical energy storage pack energy throughput, or electrical energy storage pack type.

5. The computer system of any of claims 1-4, wherein the electrical parameter value is one of internal resistance, pack-to-pack delta SoC, or pack-to-pack current delta/current split difference.

6. The computer system of any of claims 1-5, wherein the processing circuitry is further configured to:
upload electrical parameter values of the first unit and outcomes of the comparison to a data base (120) of logged electrical parameter values to update the reference data stored in the database.

7. The computer system of any of claims 1-6, wherein the processing circuitry is further configured to:
provide the indication of a power path fault to an HMI (122) in a unit.

8. The computer system of any of claims 1-7, wherein the processing circuitry is further configured to:
disconnect the faulty electrical energy storage pack from a voltage bus (109).

9. The computer system of any of claims 1-8, wherein the reference data is a preferred range or distribution of the electrical parameter for units having at least one driving or usage attribute in common with the first unit.

10. A vehicle comprising the computer system of any of claims 1-9.

11. A computer system comprising processing circuitry configured to:
acquire electrical parameter values of electrical energy storage packs in a fleet of units each equipped with at least one electrical energy storage packs,
acquire a driving or usage attribute of the units indicating driving or usage behavior of the units or electrical energy storage packs,
process the acquired electrical parameter values to determine reference data that reflect the typical electrical parameter values for a functional electrical energy storage pack of each driving or usage attribute,
store the reference data along with their associated driving or usage attribute on a memory storage device,
receive a request for reference data from a first unit of the fleet, the request including a driving or usage attribute,
provide, to the first unit, reference data associated with the requested driving or usage attribute.

12. A computer-implemented method comprising:
acquiring (S102), by processing circuitry of a computer system, an electrical parameter value of an electrical energy storage pack of a first unit in a unit fleet,
retrieving (S104), by the processing circuitry, reference data generated from logged electrical parameter values of electrical energy storage packs in the fleet of units, the retrieved reference data being determined from logged electrical parameter values associated with units having at least one driving or usage attribute in common with the first unit,
comparing (S106), by the processing circuitry, the acquired electrical parameter value with the retrieved reference data,
providing (S110), by the processing circuitry, an indication of a power path fault depending on the outcome of the comparison.

13. The method of claim 12, wherein the reference data are dynamic and adjustable based on further logged electrical parameters values from units of the fleet.

14. A computer program product comprising program code for performing, when executed by the processing circuitry, the method of any of claims 12-13.

15. A non-transitory computer-readable storage medium comprising instructions, which when executed by the processing circuitry, cause the processing circuitry to perform the method of any of claims 12-13.
